# DEMANDE DE BREVET EUROPEEN

(11) **EP 0 866 562 A1**
(43) Date de publication de la demande: **23.09.1998**
(21) Numéro de dépôt: 98200683.5
(22) Date de dépôt: 05.03.1998
(51) Int. Cl.: H03M 1/10

(54) **Dispositif de conversion analogique/numérique muni d'un agencement de calibration de gain.**

(30) Priorité: 18.03.1997 FR 9703291
(71) Demandeur: Koninklijke Philips Electronics N.V., 5621 BA Eindhoven (NL)
(72) Inventeur: Morisson, Richard, 75008 Paris (FR); Gandy, Philippe, 75008 Paris (FR); Darthenay, Frédéric, 75008 Paris (FR)
(74) Mandataire: Caron, Jean

(57) **Abrégé**

La présente invention concerne un dispositif de conversion analogique/numérique, comportant :
. un amplificateur AMP recevant une tension d'entrée V1 et délivrant tension de sortie V2, et
. un convertisseur analogique/numérique ADC2, destiné à convertir en numérique la tension de sortie V2 de l'amplificateur AMP en la comparant à des tensions de référence générées par une échelle de résistances R2 parcourues par un courant de polarisation.

Selon l'invention, ce dispositif comporte un multiplexeur MUX, pour placer l'entrée de l'amplificateur AMP à un potentiel de référence lorsqu'un signal de calibration CALG est actif, et un agencement de calibration DECM qui compare la sortie du deuxième convertisseur ADC2 à un mot binaire prédéterminé, délivre un signal de contrôle GC, qui dépend du résultat de la dite comparaison et détermine la valeur du courant de polarisation, et mémorise le signal de contrôle GC lorsque le signal de calibration CALG est inactif.

Applications : Convertisseurs analogique/numérique à deux étages.

## Description

La présente invention concerne un dispositif de conversion analogique/numérique, présentant une entrée destinée à recevoir un signal analogique d'entrée et une sortie destinée à délivrer un signal numérique de sortie, comportant :
. un amplificateur présentant une entrée destinée à recevoir le signal analogique d'entrée du dispositif et une sortie,
. un convertisseur analogique/numérique, présentant une entrée analogique reliée à la sortie de l'amplificateur et une sortie destinée à délivrer le signal numérique de sortie du dispositif, comportant une échelle de résistances parcourues par un courant débité par une source de courant réglable dite de polarisation, les noeuds intermédiaires entre les dites résistances délivrant une pluralité de tensions dites de référence destinées à être comparées au signal reçu par le convertisseur sur son entrée, les résultats de ces comparaisons servant à élaborer le signal numérique de sortie du dispositif.

Un tel dispositif est décrit dans le brevet américain n° 5,313,207. Ce dispositif est mis en oeuvre au sein d'un circuit de conversion analogique/numérique possédant une structure dite à deux étages, où un signal analogique, dit primitif, est converti en numérique par un premier convertisseur analogique/numérique, lequel fournit en sortie un signal numérique appelé mot de poids fort qui constitue une approximation de la valeur numérique du signal analogique d'entrée et qui forme ainsi la partie la plus significative du signal de sortie numérique du circuit de conversion. Le mot de poids fort est converti en analogique par un convertisseur numérique/analogique qui fournit en sortie un signal appelé signal converti qui correspond à la transposition en analogique de la valeur numérique approchée fournie par le premier convertisseur analogique/numérique. Ce signal converti prend ici la forme d'un courant qui agit sur un dispositif conforme au paragraphe introductif, dans lequel l'amplificateur reçoit en entrée le signal analogique primitif. Dans ce dispositif, le signal de contrôle est en fait constitué par le mot de poids fort, l'opération consistant à ajuster la valeur de la tension de sortie de l'amplificateur via les moyens de réglage incorporant alors la conversion en analogique du dit mot. L'amplificateur délivre ainsi en sortie un signal analogique, appelé signal résidu, représentatif d'une erreur de quantification due à l'approximation effectuée par le premier convertisseur analogique/numérique, lequel signal résidu est converti au sein du dispositif par un deuxième convertisseur analogique/numérique en un signal numérique appelé mot de poids faible qui forme ainsi la partie la moins significative du signal de sortie numérique du circuit de conversion. Le gain de l'amplificateur doit être tel qu'à l'excursion maximale de sa tension d'entrée corresponde la valeur maximale du mot de poids faible. Si la valeur du gain de l'amplificateur est trop forte, le deuxième convertisseur analogique/numérique risque de se trouver dans un mode dit de saturation, c'est-à-dire qu'il délivre le même signal de sortie pour tous les signaux d'entrée qu'il reçoit dont la valeur dépasse un certain seuil. Si la valeur du gain est trop faible, certaines valeurs disponibles en sortie du deuxième convertisseur analogique/numérique ne seront jamais atteintes par le mot de poids faible. Ces phénomènes peuvent provoquer des discontinuités dans l'évolution de la valeur du signal de sortie du dispositif en fonction de l'évolution de la valeur du signal analogique primitif, ce qui n'est pas acceptable.

L'invention a pour but de remédier à cet inconvénient en proposant un dispositif de conversion analogique/numérique dans lequel l'excursion maximale du signal de sortie du convertisseur analogique/numérique est ajustée à l'excursion maximale de la tension d'entrée de l'amplificateur qui le précède au moyen d'une boucle de régulation.

En effet, un dispositif de conversion analogique/numérique selon la présente invention est caractérisé en ce qu'il présente une entrée destinée à recevoir un signal dit de calibration, et en ce qu'il comporte des moyens pour placer l'entrée de l'amplificateur à un potentiel de référence prédéterminé lorsque le signal de calibration est actif, et un arrangement de calibration comprenant :
. un module de comparaison, actionné lorsque le signal de calibration est actif, comprenant un comparateur destiné à délivrer sur une sortie un signal représentatif d'au moins une comparaison entre le signal numérique de sortie et un mot binaire prédéterminé,
. un module de contrôle, présentant une entrée reliée à la sortie du comparateur et actionné quand le signal de calibration est actif, destiné à délivrer un signal numérique dit de contrôle, dont la valeur dépend de la valeur d'un signal reçu par le module de contrôle sur son entrée, et destiné à commander une variation de la valeur du courant débité par la source de polarisation, et
. des moyens de mémorisation dans lesquels est stockée la valeur du signal de contrôle lorsque le signal de calibration est inactif.

Un tel dispositif permet, lorsqu'il fonctionne en mode de calibration, c'est-à-dire lorsque le signal de calibration est actif, d'imposer un potentiel de valeur connue à l'entrée de l'amplificateur. La valeur du mot binaire prédéterminé correspond par convention à la valeur que doit prendre le signal numérique de sortie du dispositif lorsque, en fonctionnement normal, l'amplificateur reçoit sur son entrée une tension dont la valeur est égale à celle du potentiel de référence. En mode de calibration, toute différence existant entre le signal numérique de sortie du dispositif et le mot binaire prédéterminé est détectée par le module de comparaison, et compensée au moyen du signal de contrôle élaboré par le module de contrôle en fonction du résultat de la comparaison effectuée au sein du module de comparaison, le dit signal de contrôle agissant sur la valeur du courant traversant l'échelle de résistances délivrant les tensions de référence utilisées par le convertisseur analogique/numérique.

Une variante de l'invention est caractérisée en ce que :
. la source de courant de polarisation comporte N sources de courant disposées en parallèle entre la deuxième borne d'alimentation et une extrémité de l'échelle de résistances, la valeur Iᵢ du courant nominal débité par la source de courant de rang i (pour i=1 à N) étant égale à IO/2⁽ⁱ⁻¹⁾ où IO est une valeur prédéterminée,
. le signal de contrôle est un mot binaire de N bits dont chacun commande, lorsqu'il est au niveau actif, la conduction de l'une des N sources de courant constituant la source de courant de polarisation.

Le module de contrôle peut ainsi élaborer la valeur optimale du signal de contrôle par approximations successives, et notamment en appliquant une méthode de dichotomie. Un mode de réalisation de cette variante de l'invention est donc caractérisé en ce que :
. le signal de calibration étant actif pendant au moins N fois une durée appelée cycle de comparaison au cours de laquelle un signal analogique présent à la sortie de l'amplificateur est converti en numérique, puis comparé au mot binaire prédéterminé, le module de comparaison est muni d'un registre destiné à mémoriser au cours d'un cycle dit de contrôle, dont la durée est au moins égale à celle d'un cycle de comparaison, la valeur prise par le signal de sortie du comparateur au cours d'au moins un des cycles de contrôle précédents,
. le module de contrôle est muni de moyens pour placer systématiquement, au cours du premier cycle de contrôle, le bit de rang 1 du signal de contrôle à l'état actif,
. le module de contrôle est muni de moyens pour placer systématiquement, au cours d'un quelconque cycle de contrôle suivant, le bit de rang suivant celui du bit, dit précédent, dont l'état a été modifié au cours du cycle précédent à l'état actif, le bit précédent étant inchangé si la valeur du signal qu'il reçoit sur son entrée est identique à celle du signal reçu à l'issue du cycle de contrôle précédent et inversé sinon, le processus se répétant jusqu'à ce que le signal de calibration de niveau continu retrouve l'état inactif.

Dans un mode de réalisation préféré de l'invention, un dispositif de conversion analogique/numérique tel que décrit ci-dessus est caractérisé en ce que :
. le signal de calibration étant actif pendant au moins N.P cycles de comparaison, chaque cycle de contrôle comprend P cycles de comparaison,
. le module de comparaison est muni d'un registre, destiné à mémoriser les valeurs prises par le signal de sortie du comparateur à l'issue de chacune des P comparaisons successives effectuées au cours d'un même cycle de contrôle, et d'un module de pondération, destiné délivrer sur une sortie un signal dont la valeur est représentative d'une moyenne des dites valeurs, la dite sortie formant la sortie du module de comparaison.

La pondération des résultats de P comparaisons successives permet d'éviter des oscillations dues à des corrections intempestives. En effet, la sortie du module de comparaison incluant un module de pondération est représentative d'une tendance matérialisée par au moins P/2 résultats de comparaison. Cette pondération permet donc de limiter les effets que produirait une différence fortuite entre le signal numérique de sortie du dispositif et le mot binaire prédéterminé, qui serait due par exemple à une conversion erronée.

Ainsi qu'exposé plus haut, tel un dispositif de conversion analogique/numérique peut être avantageusement mis en oeuvre au sein d'un circuit de conversion analogique/numérique présentant une structure dite à deux étages. L'invention concerne donc également un circuit de conversion analogique/numérique, présentant une entrée destinée à recevoir un signal analogique d'entrée et une sortie destinée à délivrer un signal numérique de sortie, comportant :
. un premier dispositif de conversion analogique/numérique présentant une entrée et une sortie respectivement destinées à recevoir le signal analogique d'entrée du circuit et à délivrer un signal de nature numérique, appelé mot de poids fort, constituant la partie la plus significative du signal numérique de sortie du circuit,
. un convertisseur numérique/analogique destiné à recevoir le mot de poids fort et à le convertir en un signal de sortie de nature analogique, appelé signal converti,
. un deuxième dispositif de conversion analogique/numérique, présentant une entrée analogique destinée à recevoir la différence entre le signal converti et le signal d'entrée du circuit, et une sortie destinée à délivrer un signal de nature numérique, appelé mot de poids faible, constituant la partie la moins significative du signal numérique de sortie du circuit,
   circuit de conversion caractérisé en ce qu'au moins un des deux dispositifs de conversion analogique/numérique est tel que décrit plus haut.

L'invention sera mieux comprise à l'aide de la description suivante de quelques modes de réalisation, faite à titre d'exemple non-limitatif et en regard des dessins annexés, dans lesquels :
- la figure 1 est un schéma de principe représentant un circuit de conversion analogique/numérique à deux étages qui met en oeuvre l'invention,
- la figure 2 est un schéma électrique décrivant une source de courant incluse dans un tel amplificateur, et
- la figure 3 est un schéma de principe représentant un agencement de calibration présent dans une variante de l'invention.

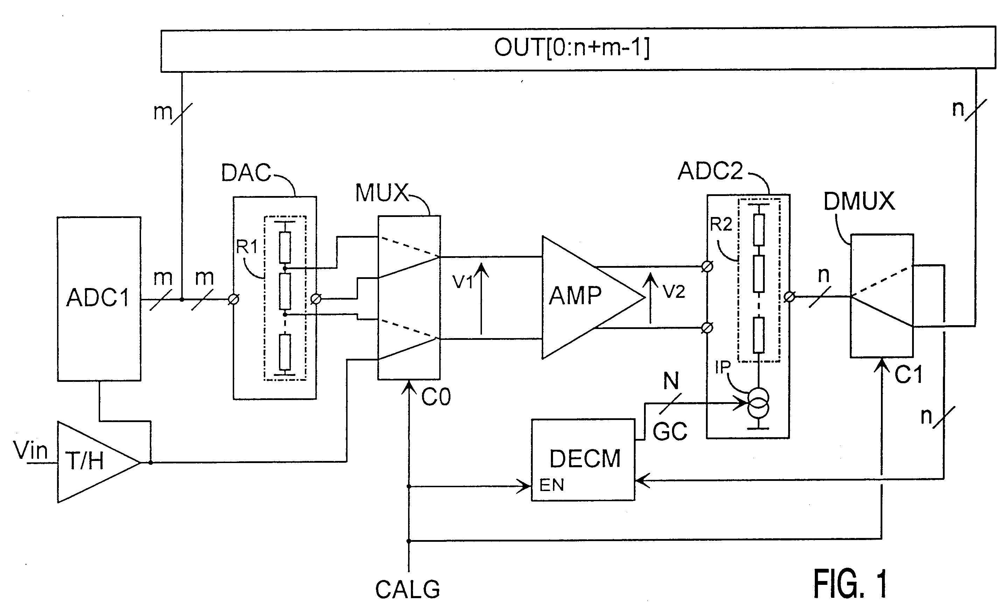

La figure 1 représente schématiquement un circuit de conversion analogique/numérique à deux étages qui met en oeuvre l'invention. Ce circuit présente une entrée destinée à recevoir un signal analogique d'entrée Vin, via dans cet exemple un suiveur/bloqueur T/H, et une sortie destinée à délivrer un signal numérique de sortie OUT[O:n+m-1], et comporte :
. un premier convertisseur analogique/numérique ADC1 présentant une entrée et une sortie respectivement destinées à recevoir le signal analogique d'entrée Vin du circuit et à délivrer un signal OUT[n:m-1] de nature numérique, appelé mot de poids fort, constituant la partie la plus significative du signal numérique de sortie OUT[O:n+m-1] du circuit,
. un convertisseur numérique/analogique DAC destiné à recevoir le mot de poids fort OUT[n:m-1] et à le convertir en un signal de sortie de nature analogique, appelé signal converti,
. un dispositif de conversion analogique/numérique, présentant une entrée analogique destinée à recevoir une tension V1, appelée signal résidu, qui représente la différence entre le signal converti et le signal d'entrée Vin du circuit, et une sortie destinée à délivrer un signal OUT[O:n-1] de nature numérique, appelé mot de poids faible, constituant la partie la moins significative du signal numérique de sortie OUT[O:n+m-1] du circuit.

Ce dispositif de conversion comporte :
. un amplificateur AMP présentant une sortie délivrant une tension V2 et une entrée différentielle destinée à recevoir le signal résidu V1,
. un deuxième convertisseur analogique/numérique ADC2, présentant une entrée analogique reliée à la sortie de l'amplificateur AMP et recevant donc la tension V2, et une sortie destinée à délivrer le signal numérique de sortie du dispositif qui constitue le mot de poids faible OUT[O:n-1], et qui comporte une échelle R2 de résistances parcourues par un courant IP débité par une source de courant réglable dite de polarisation, les noeuds intermédiaires entre les dites résistances délivrant une pluralité de tensions dites de référence destinées à être comparées à la tension V2 reçue par le convertisseur ADC2 sur son entrée, les résultats de ces comparaisons servant à élaborer le signal numérique de sortie du dispositif OUT[O:n-1].

Le dispositif de conversion présente en outre une entrée destinée à recevoir un signal de calibration CALG. Il comporte un multiplexeur MUX pour placer l'entrée de l'amplificateur AMP à un potentiel de référence lorsque le signal de calibration de gain CALG est actif. Dans cet exemple, le convertisseur numérique/analogique DAC réalise la conversion sur la base de tensions de référence élaborées au moyen d'une échelle R1 de résistances de valeurs nominales identiques et disposées en série entre deux bornes d'alimentation. Cette échelle de résistances est avantageusement choisie comme étant la même que celle qui est utilisée au sein du premier convertisseur analogique/numérique ADC1. Ainsi, la valeur de la tension aux bornes d'une des résistances, qui correspond à la valeur analogique du bit le moins significatif du mot de poids fort OUT[n:m-1], détermine l'erreur de quantification maximale commise par le premier convertisseur analogique/numérique, et donc la valeur maximale du signal résidu V1. Le potentiel de référence utilisé pour la calibration du gain du dit amplificateur doit donc être égal à cette valeur maximale.

Le dispositif comporte de plus un agencement de calibration DECM, qui, lorsque le signal de calibration CALG est actif, reçoit par l'intermédiaire du démultiplexeur DMUX le mot de poids faible OUT[O:n-1], et le compare à un mot binaire prédéterminé, dont la valeur est, dans cette exemple, la valeur maximale que peut prendre la sortie du deuxième convertisseur analogique/numérique ADC2.

Un agencement de calibration DECM permet de faire varier la valeur du courant IP débité par la source de polarisation. Ceci permet d'ajuster les valeurs des tensions de référence générées par l'échelle de résistances R2 au sein du deuxième convertisseur analogique/numérique ADC2, et donc en particulier d'ajuster la valeur de la plus grande de ces tensions pour qu'elle corresponde à la valeur maximale que peut prendre le signal résidu V1. La source de polarisation doit être toujours conductrice puisqu'elle polarise l'échelle R2 de résistances, les tensions de référence ainsi générées étant indispensables au fonctionnement du dispositif. La valeur du courant IP débité par la source de polarisation évolue de la manière suivante : lorsque la valeur du mot de poids faible OUT[O:n-1] est inférieure à la valeur maximale que peut prendre la sortie du deuxième convertisseur analogique/numérique ADC2, cela signifie que les tensions de référence utilisées par le dit convertisseur ont des valeurs trop importantes, ce qui doit être compensé par une diminution de la valeur du courant IP débité par la source de polarisation. Si la valeur du mot de poids faible OUT[O:n-1] est égale à la valeur maximale que peut prendre la sortie du deuxième convertisseur analogique/numérique ADC2, cela peut signifier que les tensions de référence ont des valeurs trop faibles, et que le deuxième convertisseur analogique/numérique ADC2 se trouve dans un mode dit de saturation, c'est-à-dire qu'il délivre le même signal de sortie pour tous les signaux d'entrée qu'il reçoit dont la valeur dépasse un certain seuil. Les valeurs des tensions de référence sont donc augmentées au moyen du signal de contrôle CALG qui opére alors une augmentation de la valeur du courant IP débité par la source de polarisation. Si, après cette correction, il s'avère que la valeur du signal numérique de sortie OUT[O:n-1] du dispositif est toujours égale à la valeur maximale que peut prendre la sortie du deuxième convertisseur analogique/numérique ADC2, cela signifie bien que les valeurs des tensions de référence sont trop faibles et que le deuxième convertisseur analogique/numérique se trouve en mode de saturation. Le courant débité par la source de polarisation doit donc être à nouveau augmenté. L'équilibre recherché est signalé par un changement du résultat de la comparaison décrite plus haut. Lorsque ce changement survient, le réglage précédent de la valeur du signal de contrôle CALG, qui a été préalablement mémorisée dans un registre, est validé et sera utilisé en mode de fonctionnement normal du dispositif.

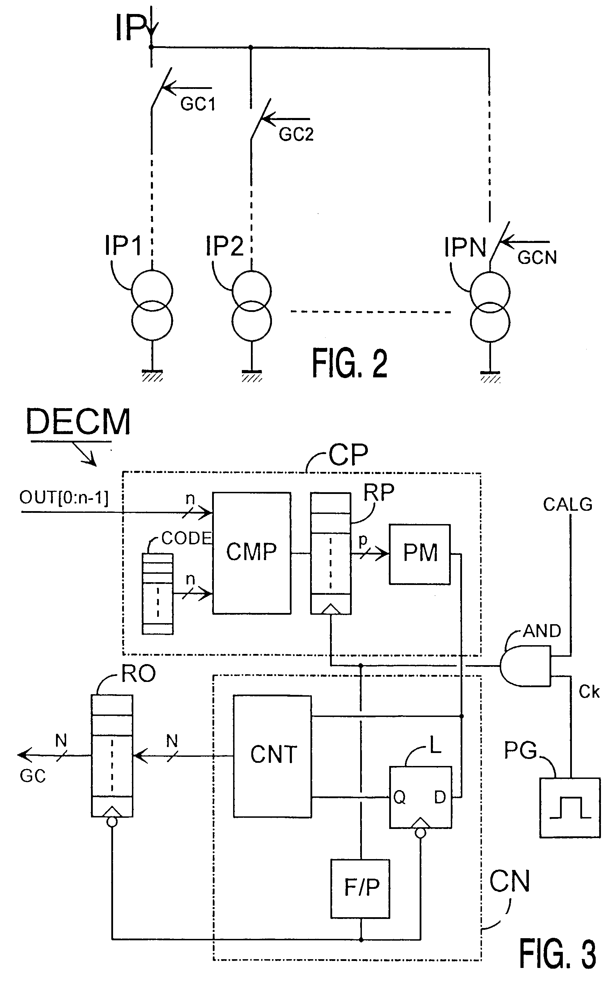

La figure 2 décrit schématiquement un mode de réalisation de la source de polarisation, et le dispositif employé pour régler la valeur du courant IP débité par celle-ci. Cette source comporte N sources de courant disposées en parallèle entre la masse du circuit et un noeud commun à toutes les sources, qui est destiné à être parcouru par le courant IP. La valeur IPᵢ du courant nominal débité par la source de courant de rang i (pour i=1 à N) est égale à IO/2⁽ⁱ⁻¹⁾ où IO est une valeur prédéterminée. Conformément à ce qui a été exposé précédemment, le signal de contrôle GC est un mot binaire de N bits dont chaque bit GCi, pour i=1 à N, commande, lorsqu'il est à l'état actif, la conduction de l'une des N sources de courant IPᵢ, pour i=1 à N, constituant la source de polarisation. A tout moment, au moins un des bits du signal de contrôle GC est à l'état actif afin de maintenir la conduction de la source de polarisation.

La figure 3 représente schématiquement l'agencement de calibration DECM présent dans une variante de l'invention. Cet arrangement comporte :
. un module de comparaison CP, comprenant un comparateur CMP destiné à délivrer sur une sortie un signal représentatif d'au moins une comparaison entre le signal numérique de sortie OUT[O:n-1] du deuxième convertisseur ADC2 et un mot binaire prédéterminé, qui est stocké dans un registre CODE et dont la valeur est la valeur maximale que peut prendre la sortie du deuxième convertisseur analogique/numérique ADC2,
. un module de contrôle CN, présentant une entrée reliée à la sortie du module de comparaison CP, destiné à délivrer le signal de contrôle GC, dont l'élaboration sera décrite plus loin, et
. un registre RO dans lequel est stockée la valeur du signal de contrôle GC lorsque le dispositif de conversion se trouve en mode de fonctionnement normal.

L'agencement de calibration DECM reçoit le signal de calibration CALG qui est actif pendant au moins N fois une durée appelée cycle de comparaison au cours de laquelle la tension de sortie V2 de l'amplificateur AMP est convertie en numérique par le deuxième convertisseur analogique/numérique ADC2, puis comparée au mot binaire stocké dans le registre CODE. Le module de comparaison CP est muni d'un registre RP destiné à mémoriser au cours d'un cycle dit de contrôle, dont la durée est au moins égale à celle d'un cycle de comparaison, la valeur prise par le signal de sortie du comparateur CMP au cours d'au moins un des cycles de contrôle précédents.

Dans la variante de l'invention décrite ici, le signal de calibration CALG est en fait actif pendant au moins N.P cycles de comparaison, et chaque cycle de contrôle comprend P cycles de comparaison. Le registre RP du module de comparaison CP est cadencé par un signal d'horloge Ck délivré par un générateur d'impulsions PG, et validé par le signal de calibration CALG au moyen d'une porte "et logique" AND. Ce registre RP est destiné à mémoriser les valeurs prises par le signal de sortie du comparateur CMP à l'issue de chacune des P comparaisons successives effectuées au cours d'un même cycle de contrôle. Le module de comparaison CP est de plus muni d'un module de pondération PM destiné délivrer sur une sortie un signal dont la valeur est représentative d'une moyenne des dites valeurs, la dite sortie formant la sortie du module de comparaison CP. Ainsi, le signal de sortie du module de comparaison est représentatif d'une tendance matérialisée par au moins P/2 résultats de comparaison identiques, ce qui permet d'éviter des oscillations résultant de corrections intempestives provoquées par des différences fortuites entre le signal numérique de sortie OUT[O:n-1] du deuxième convertisseur analogique/numérique ADC2 qui seraient dues par exemple à une conversion erronée. Le module de contrôle comprend une bascule mémoire L destinée à mémoriser au cours d'un cycle de contrôle la valeur du signal de sortie du module de comparaison CP à l'issue du cycle précédent. Un cycle de contrôle durant P cycles de comparaison, cette bascule L est cadencée par un signal issu d'un diviseur de fréquence F/P, qui reçoit en entrée le signal d'horloge Ck et délivre un signal dont la fréquence est P fois plus faible. La conduction de la source de courant étant assujettie au signal de contrôle GC, un cycle de calibration doit impérativement intervenir dès la mise sous tension du dispositif. Au cours du premier cycle de contrôle de ce premier cycle de calibration, les tensions de référence étant toutes nulles, la sortie du module de comparaison CP signale qu'une augmentation du courant IP débité par la source de polarisation est nécessaire. Le module de contrôle CN place donc, au cours du premier cycle de contrôle, le bit de rang 1 GC1 du signal de contrôle GC à l'état actif. Au cours d'un quelconque cycle de contrôle suivant, le module de contrôle CN place systématiquement le bit de rang suivant celui du bit, dit précédent, dont l'état a été modifié au cours du cycle précédent à l'état actif, le bit précédent étant inchangé si la valeur du signal délivré par le module de comparaison est identique à celle du signal délivré à l'issue du cycle de contrôle précédent, et inversé sinon. Ce processus se répète jusqu'à ce que le signal de calibration CALG retrouve l'état inactif, provoquant ainsi la mémorisation du signal de contrôle GC dans le registre RO.

## Revendications

1. Dispositif de conversion analogique/numérique, présentant une entrée destinée à recevoir un signal analogique d'entrée et une sortie destinée à délivrer un signal numérique de sortie, comportant :
. un amplificateur présentant une entrée destinée à recevoir le signal analogique d'entrée du dispositif et une sortie,
. un convertisseur analogique/numérique, présentant une entrée analogique reliée à la sortie de l'amplificateur et une sortie destinée à délivrer le signal numérique de sortie du dispositif, comportant une échelle de résistances parcourues par un courant débité par une source de courant réglable dite de polarisation, les noeuds intermédiaires entre les dites résistances délivrant une pluralité de tensions dites de référence destinées à être comparées au signal reçu par le convertisseur sur son entrée, les résultats de ces comparaisons servant à élaborer le signal numérique de sortie du dispositif,
dispositif de conversion caractérisé en ce qu'il présente une entrée destinée à recevoir un signal dit de calibration, et en ce qu'il comporte des moyens pour placer l'entrée de l'amplificateur à un potentiel de référence prédéterminé lorsque le signal de calibration est actif, et un arrangement de calibration comprenant :
. un module de comparaison, actionné lorsque le signal de calibration est actif, comprenant un comparateur destiné à délivrer sur une sortie un signal représentatif d'au moins une comparaison entre le signal numérique de sortie et un mot binaire prédéterminé,
. un module de contrôle, présentant une entrée reliée à la sortie du comparateur et actionné quand le signal de calibration est actif, destiné à délivrer un signal numérique dit de contrôle, dont la valeur dépend de la valeur d'un signal reçu par le module de contrôle sur son entrée, et destiné à commander une variation de la valeur du courant débité par la source de polarisation, et
. des moyens de mémorisation dans lesquels est stockée la valeur du signal de contrôle lorsque le signal de calibration est inactif.

2. Dispositif de conversion analogique/numérique selon la revendication 1, caractérisé en ce que :
. la source de courant de polarisation comporte N sources de courant disposées en parallèle entre la deuxième borne d'alimentation et une extrémité de l'échelle de résistances, la valeur Iᵢ du courant nominal débité par la source de courant de rang i (pour i=1 à N) étant égale à IO/2⁽ⁱ⁻¹⁾ où IO est une valeur prédéterminée,
. le signal de contrôle est un mot binaire de N bits dont chacun commande, lorsqu'il est au niveau actif, la conduction de l'une des N sources de courant constituant la source de courant de polarisation.

3. Dispositif de conversion analogique/numérique selon la revendication 2, caractérisé en ce que :
. le signal de calibration étant actif pendant au moins N fois une durée appelée cycle de comparaison au cours de laquelle un signal analogique présent à la sortie de l'amplificateur est converti en numérique, puis comparé au mot binaire prédéterminé, le module de comparaison est muni d'un registre destiné à mémoriser au cours d'un cycle dit de contrôle, dont la durée est au moins égale à celle d'un cycle de comparaison, la valeur prise par le signal de sortie du comparateur au cours d'au moins un des cycles de contrôle précédents,
. le module de contrôle est muni de moyens pour placer systématiquement, au cours du premier cycle de contrôle, le bit de rang 1 du signal de contrôle à l'état actif,
. le module de contrôle est muni de moyens pour placer systématiquement, au cours d'un quelconque cycle de contrôle suivant, le bit de rang suivant celui du bit, dit précédent, dont l'état a été modifié au cours du cycle précédent à l'état actif, le bit précédent étant inchangé si la valeur du signal qu'il reçoit sur son entrée est identique à celle du signal reçu à l'issue du cycle de contrôle précédent et inversé sinon, le processus se répétant jusqu'à ce que le signal de calibration de niveau continu retrouve l'état inactif.

4. Dispositif de conversion analogique/numérique selon la revendication 3, caractérisé en ce que :
. le signal de calibration étant actif pendant au moins N.P cycles de comparaison, chaque cycle de contrôle comprend P cycles de comparaison,
. le module de comparaison est muni d'un registre, destiné à mémoriser les valeurs prises par le signal de sortie du comparateur à l'issue de chacune des P comparaisons successives effectuées au cours d'un même cycle de contrôle, et d'un module de pondération, destiné délivrer sur une sortie un signal dont la valeur est représentative d'une moyenne des dites valeurs, la dite sortie formant la sortie du module de comparaison.

5. Circuit de conversion analogique/numérique, présentant une entrée destinée à recevoir un signal analogique d'entrée et une sortie destinée à délivrer un signal numérique de sortie, comportant :
. un premier dispositif de conversion analogique/numérique présentant une entrée et une sortie respectivement destinées à recevoir le signal analogique d'entrée du circuit et à délivrer un signal de nature numérique, appelé mot de poids fort, constituant la partie la plus significative du signal numérique de sortie du circuit,
. un convertisseur numérique/analogique destiné à recevoir le mot de poids fort et à le convertir en un signal de sortie de nature analogique, appelé signal converti,
. un deuxième dispositif de conversion analogique/numérique, présentant une entrée analogique destinée à recevoir la différence entre le signal converti et le signal d'entrée du circuit, et une sortie destinée à délivrer un signal de nature numérique, appelé mot de poids faible, constituant la partie la moins significative du signal numérique de sortie du circuit,
circuit de conversion caractérisé en ce qu'au moins un des deux dispositifs de conversion analogique/numérique est conforme à l'une quelconque des revendications 1 à 4.
